Europäisches Patentamt

European Patent Office

Office européen des brevets

(11) Numéro de publication : **0 463 907 A1**

# (12) DEMANDE DE BREVET EUROPEEN

(21) Numéro de dépôt : **91401538.3**

(22) Date de dépôt : **11.06.91**

(51) Int. Cl.[5] : **H01L 31/0352**

(30) Priorité : **26.06.90 FR 9008004**

(43) Date de publication de la demande :
**02.01.92 Bulletin 92/01**

(84) Etats contractants désignés :
**DE GB**

(71) Demandeur : **THOMSON-CSF**
**51, Esplanade du Général de Gaulle**
**F-92800 Puteaux (FR)**

(72) Inventeur : **Delacourt, Dominique**
**Thomson-CSF SCPI-Cedex 67**
**92045 Paris La Défense (FR)**
Inventeur : **Papuchon, Michel**
**Thomson-CSF SCPI-CEDEX 67**
**92045 Paris La Défense (FR)**
Inventeur : **Chevoir, François**
**Thomson-CSF SCPI-CEDEX 67**
**92045 Paris La Défense (FR)**

(74) Mandataire : **Guérin, Michel et al**
**THOMSON-CSF SCPI**
**F-92045 PARIS LA DEFENSE CEDEX 67 (FR)**

(54) Détecteur d'ondes électromagnétiques.

(57) L'invention concerne un détecteur d'ondes électromagnétiques comportant plusieurs empilements de couches de matériaux semiconducteurs (1 à 4) chaque empilement constituant un puits quantique asymétrique à barrière échelonnée et possède deux niveaux d'énergie située l'un ($e_1$) au-dessous du niveau d'énergie de l'échelon de barrière intermédiaire (3) et l'autre ($e_2$) situé au-dessus. Des moyens permettent d'appliquer un champ électrique à la structure.
Applications : Détecteurs d'ondes électromagnétiques

FIG.4b

L'invention concerne un détecteur d'onde électromagnétique et plus particulièrement un détecteur d'onde à semiconducteurs à puits quantique.

A l'heure actuelle, plusieurs solutions peuvent être utilisées pour détecter une onde électromagnétique. Parmi ces solutions, on peut citer l'utilisation de :

1) Matériaux semiconducteurs à largeur de bande interdite adaptée

2) Matériaux semiconducteurs dopés

3) Matériaux semiconducteurs III-V associés en structures à puits quantiques multiples.

La première solution (1) consiste à mettre en oeuvre des matériaux semiconducteurs dont la largeur de bande interdite est plus faible que l'énergie photonique $h\nu$ de l'onde à détecter qui permet donc de faire passer des électrons de la bande de valence à celle de conduction. Ces électrons sont ensuite collectés à l'aide d'un circuit extérieur et sont à l'origine d'un photocourant qui permet la détection

La deuxième solution (2) concerne l'utilisation de semiconducteurs présentant une largeur de bande interdite plus grande que l'énergie photonique à détecter ce qui est possible en ayant recours à un dopage des matériaux utilisés. Ce dopage permet de faire apparaître un niveau donneur d'électrons correspondant aux impuretés à l'origine du dopage. A partir de ce niveau énergétique plus proche du bas de la bande de conduction que ne l'est le sommet de la bande de valence, vont pouvoir se produire des transitions électroniques vers la bande de conduction, rendant libres et détectables les électrons ayant subi ces transitions sous l'effet d'un champ électromagnétique.

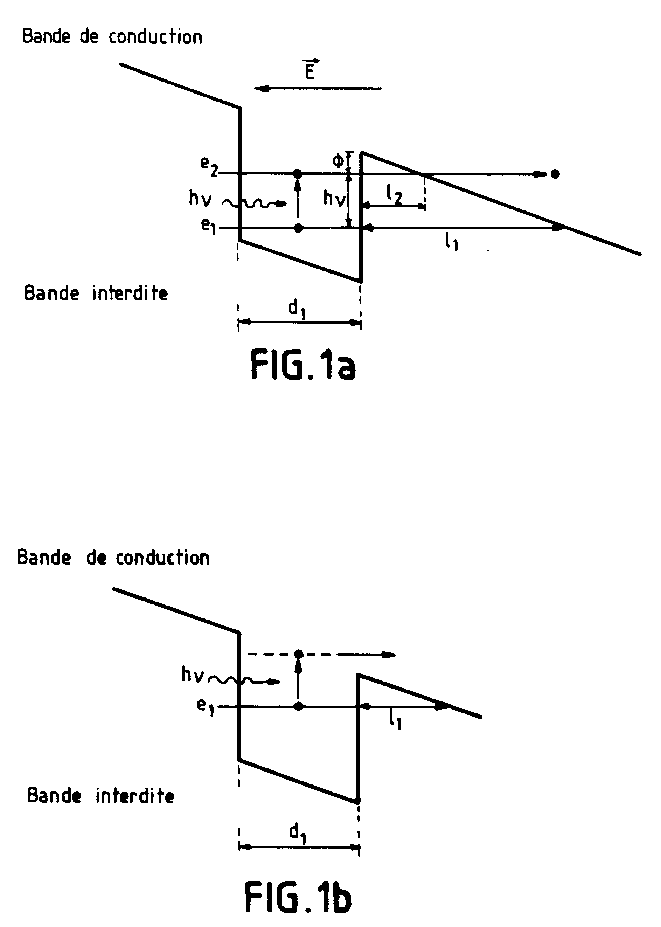

La troisième solution (3) est basée sur l'occurrence de transitions électroniques entre niveaux permis d'énergie ($e_1$ et $e_2$) au sein de la bande de conduction de structures quantiques semiconductrices. La figure 1a donne un exemple de ce type de transition dans un puits présentant deux niveaux discrets d'énergie permise pour les électrons. L'application d'un champ électrique à ce type de configuration permet d'extraire du puits de manière préférentielle les électrons situés sur le deuxième niveau quantique. Ainsi, la collection dans le circuit électrique extérieur de ces électrons provenant du deuxième niveau quantique sur lequel ils ont été portés par un éclairement ($h\nu$), permet la détection de ce dernier. L'invention concerne un détecteur correspondant à cette troisième solution.

Le type de détecteurs auquel s'applique l'invention, est donc basé sur l'occurrence, sous l'effet d'un éclairement $h\nu$, de transitions électroniques au sein de la bande de conduction de puits quantiques semiconducteurs. Le principe de fonctionnement de ces détecteurs est donc d'utiliser ces transitions pour placer les électrons initialement situés sur le niveau fondamental du puits, à un niveau énergétique leur permettant de sortir facilement du puits sous l'effet d'un champ électrique appliqué. Jusqu'à présent deux configurations ont été proposées pour rendre possible ce type de fonctionnement. Une première configuration consiste à utiliser un puits quantique présentant deux niveaux $e_1$ et $e_2$ d'énergie permise pour les électrons dans la bande de conduction. Comme cela est représenté en figure 1a, sous l'effet d'un éclairement représenté par son énergie photonique $h\nu$ des transitions électroniques peuvent se produire du niveau $e_1$ vers le niveau $e_2$. L'application d'un champ électrique E à la structure permet ensuite de faire franchir aux électrons situés sur le niveau $e_2$, la barrière de potentiel $\Phi$ afin de les extraire du puits. Les électrons participent alors à un photocourant qui permet la détection de l'éclairement comme cela est décrit dans les documents :

"New 10 $\mu$m infrared detector using intersubband absorption in resonant tunneling GaAsAs superlattices ", B. F. Levine, K. K. Choi, C. G. Bethea, J. Walker and R. J. Malik, APL 50 (16), 20 April 1987, p. 1092

"Multiple quantum well 10 $\mu$m GaAs/Al$x$ Ga$_{1-x}$ As infrared detector with improved responsivity ", K. K. Choi, B. F. Levine, C. G. Bethea, J. Walker and R. J. Malik, APL 50 (25), 22 June 1987, p. 1814

"Quantum well avalanch multiplication initiated by 10 $\mu$m intersubband absorption and photoexcited tunneling", B. F. Levine, K. K. Choi, C. G. Bethea, J. Walker and R. J. Malik, APL 51 (12), 21 September 1987, p. 934.

Une deuxième configuration est basée sur l'emploi d'un puits ne présentant qu'un seul niveau, séparé du haut de la barrière formant le puits par une énergie voisine de l'énergie photonique $h\nu$ de l'onde électromagnétique à détecter comme cela est représenté en figure 1b et est décrit dans les documents :

"GaAs/AlGaAs quantum-well long-wavelength infrared (LWIR) detector with a detectivity comparable to HgCdTe ", B. F. Levine, C. G. Bethea, G. Hasnain, J. Walker, R. J. Malik, Elec. Letters, Vol. 24, n° 12, 9/6/88, p. 747

"High detectivity D* = 1.0 x 10$^{10}$ cm Hz/W GaAs/AlGaAs multiquantum well = 8.3 $\mu$m infrared detector", B.F. Levine, C. G. Bethea, G. Hasnain, J. Walker and R. J. Malik, APL 53 (4), 25 July 1988, p. 296.

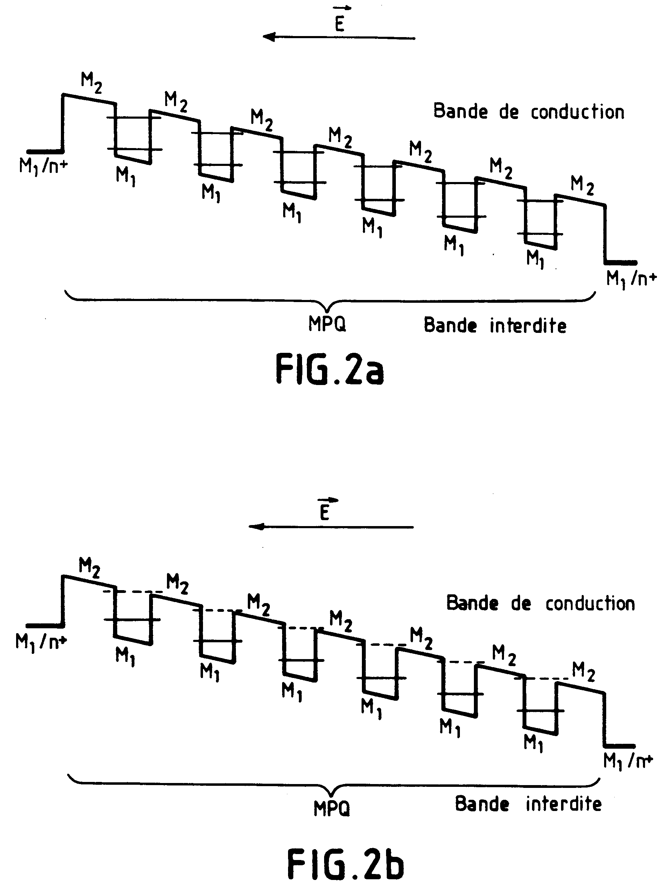

Pour obtenir une absorption importante de l'éclairement à détecter, on utilise un grand nombre de puits au sein des détecteurs basés sur ce principe quantique, et ce quelle que soit la configuration choisie. Ainsi la bande de conduction de ces détecteurs à Multi-Puits Quantiques (MPQ) peut être symbolisée par les figures 2a et 2b correspondant respectivement aux deux types de transition qui viennent d'être évoqués. Ce type de structure est basé sur l'empilement périodique de couches d'un premier matériau $M_1$ et d'un deuxième $M_2$. Les largeurs de bande interdite des deux matériaux sont différentes afin d'obtenir des puits de potentiel pour les électrons dans la bande de conduction. Les couches de contact situées de part et d'autre de la région périodique désignée par MPQ, peuvent par exemple être constituées de couches de matériau $M_1$ fortement dopées n et notées $M_1/n+$. Pour augmenter le nombre de transitions possibles, on a recours généralement au dopage de type n de la zone MPQ.

Parmi les caractéristiques présentées par ces configurations, on peut noter, en se reportant à nouveaux aux figures 1a et 1b les éléments suivants :

– Dans le cas de la configuration de la figure 1a, les transitions se produisent entre deux niveaux situés au-dessous de la barrière de potentiel séparant les puits. Par conséquent, les électrons situés sur les deux niveaux présentent un confinement important dans la largeur $d_1$ des puits, d'où une efficacité de transition importante entre les deux niveaux. En effet, l'absorption due aux transitions électroniques entre $e_1$ et $e_2$, est un des éléments qui gouverne la réponse du détecteur. Cette absorption est proportionnelle au dipôle d'interaction $\mu_z$ entre les deux niveaux. $\mu_z$ s'écrit :

$$\mu_z = \int_{-\infty}^{+\infty} \Psi_2(z)\ \Psi_1(z)\ z\ dz$$

où $\psi_1(z)$ et $\psi_2(z)$ sont les fonctions d'onde électroniques réelles attachées respectivement aux niveaux $e_1$ et $e_2$. Or pour une épaisseur de puits donnée, $\mu_z$ sera d'autant plus élevé que les extensions des deux fonctions d'ondes seront voisines. Le fonctionnement de ce type de détecteur tire parti de la différence de mobilité dans la direction perpendiculaire au plan des couches constituant les puits, entre les électrons situés sur le niveau $e_1$ et ceux situés sur le niveau $e_2$. En effet, pour être extraits du puits, les électrons situés sur le niveau $e_2$ ont une barrière de potentiel $\Phi$ à franchir plus faible que les électrons situés sur le niveau $e_1$ retenus sous champ dans le puits par une barrière $\Phi + h\nu$. De plus, la largeur de cette barrière est plus fine ($l_2$) pour le niveau $e_2$ que pour le niveau $e_1$ ($l_1$) et ce à cause du profil de potentiel imprimé à la structure par le champ électrique utilisé pour la collection des photo-électrons. Néanmoins, cette barrière de potentiel à franchir limite les performances du détecteur car elle limite la différence de mobilité dans le transport perpendiculaire aux couches semiconductrices entre les électrons situés sur le niveau $e_1$ et ceux situés sur le niveau $e_2$, les deux niveaux étant séparés par l'énergie $h\nu$ donnée par la longueur d'onde centrale de la courbe de réponse du détecteur.

– Si l'on observe maintenant la structure de la figure 1b, on constate que les électrons excités par le champ électromagnétique à détecter n'ont plus de barrière à franchir pour être extraits du puits, ce qui favorise leur participation au photocourant. Par contre, le niveau auquel sont portés les électrons photo-excités à partir du niveau $e_1$, n'est pas lié et la probabilité de transition beaucoup plus petite que dans le cas de la figure 1a, compte tenu de la très faible localisation dans la zone du puits, des électrons situés sur ce niveau libre. En d'autres termes, la fonction d'onde associée à ce niveau n'est pas confinée dans la zone du puits et le dipôle d'interaction $\mu_z$ beaucoup plus faible.

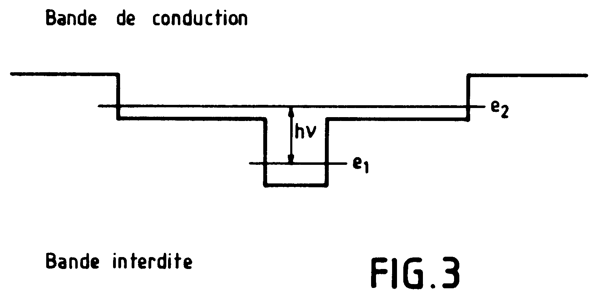

Toujours à titre de comparaison entre les deux configurations connues des figures 1a et 1b, signalons également que dans le cas de la figure 1a, la distance $l_2$ dépend directement du champ appliqué $\vec{E}$ à la structure. Plus on cherche à diminuer $l_2$ plus on doit appliquer un champ $\vec{E}$ important et plus on diminue $l_1$, ce qui a pour conséquence d'augmenter le courant d'obscurité de la structure. Ce problème est différent dans le cas de la figure 1b où des champs plus faibles peuvent être suffisants pour collecter efficacement les porteurs photo-excités, mais où se pose, nous l'avons vu, le problème de la faible probabilité de transition entre le niveau fondamental du puits et le niveau virtuel excité. Pour associer d'une part une réponse importante due à une forte probabilité de transition entre niveau fondamental et niveau excité, et d'autre part un très faible courant d'obscurité, une solution utilisant des puits symétriques à double barrière échelonnée tels que celui représenté sur la figure 3 a été proposée dans la Demande de Brevet français n° 89 08961. Cette solution est basée sur les différenciations entre l'extension de la fonction d'onde $\psi_2$ attachée au niveau $e_2$ et celle de la fonction d'onde $\psi_1$ attachée au niveau $e_1$, pour favoriser l'extraction du puits des électrons situés sur le niveau 2 tout en maintenant un confinement important pour les électrons situés sur le niveau 1. Cependant, il est possible d'encore favoriser ce comportement en utilisant des puits asymétriques tels qu'ils sont décrits dans ce qui suit.

Pour répondre au problème posé qui consiste à obtenir sur un même détecteur basé sur l'occurrence de transitions intrabandes au sein de la bande de conduction de structures à puits quantiques multiples, une réponse élevée et un faible courant d'obscurité, il est nécessaire que la barrière à franchir soit très différente pour les électrons situés sur le niveau excité et pour ceux situés sur le niveau fondamental.

L'invention concerne donc un détecteur d'ondes électromagnétiques, caractérisé en ce qu'il comporte :

– un empilement de couches en matériau semiconducteur constituant un puits quantique dont le profil de potentiel asymétrique présente une barrière échelonnée c'est-à-dire possède un échelon de barrière intermédiaire et possédant deux niveaux d'énergie dont l'un des niveaux est inférieur au niveau d'énergie de l'échelon de barrière intermédiaire et l'autre niveau est supérieur au niveau d'énergie de cet échelon de barrière intermédiaire ;

– des moyens d'application d'un champ électrique à la structure ;

– des moyens de détection d'un courant électrique connecté aux bornes de la structure.

Plus précisément, l'invention concerne un détecteur d'onde électromagnétique, caractérisé en ce qu'il comprend :

a) une structure semiconductrice possédant au moins un empilement d'une première, deuxième, troisième et quatrième couches dont les largeurs des bandes interdites permettent d'obtenir le profil suivant d'énergie potentielle correspondant au bas de la bande de conduction pour les électrons :

– énergie la plus basse pour la deuxième couche ;

– énergie intermédiaire pour la troisième couche , cette troisième couche constituant une barrière interne ;

– énergies de valeurs supérieures pour les première et quatrième couches constituant les barrières du puits ;

ladite structure est telle que :

– l'énergie correspondant à un premier niveau électronique permis est inférieure à l'énergie intermédiaire du bas de la bande de conduction du matériau de la troisième couche ;

– l'énergie correspondant à un deuxième niveau électronique, est comprise entre l'énergie intermédiaire du bas de la bande de conduction du matériau de la troisième couche et les énergies potentielles du bas de la bande de conduction des matériaux des première et quatrième couches ;

b) des moyens d'application d'un champ électrique à la structure orienté dans le sens de la troisième couche vers la deuxième couche ;

c) des moyens de détection d'un courant électrique connectés aux bornes de la structure.

Les différents objets et caractéristiques de l'invention apparaîtront plus clairement dans la description qui va suivre faite à titre d'exemple et dans les figures annexées qui représentent :

– les figures 1a, 1b, 2a, 2b et 3, des dispositifs connus dans la technique et déjà décrits précédemment ;

– les figures 4a, 4b et 5, un exemple de réalisation selon l'invention ;

– la figure 6a, un exemple de matériaux et d'épaisseurs de couches utilisés pour réaliser un dispositif connu ;

– la figure 6b, un exemple de matériaux et d'épaisseurs de couches utilisés pour réaliser l'invention ;

– la figure 7, un exemple de réalisation détaillé du dispositif de l'invention.

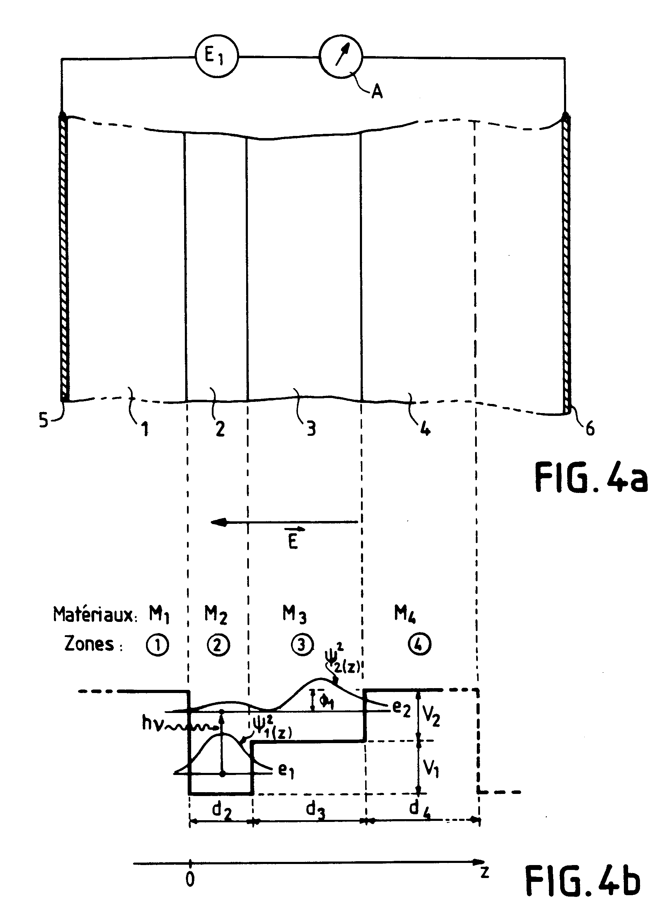

Selon l'invention, le détecteur d'ondes électromagnétiques est réalisé à l'aide de couches de matériaux semiconducteurs de façon à réaliser au moins un puits quantique présentant un profil de potentiel particulier tel que présenté en figure 4b. Un tel puits ainsi configuré peut être dit "asymétrique à barrière échelonnée". Ce type de profil permet de diminuer la valeur du champ électrique à appliquer pour obtenir l'asymétrie nécessaire à l'extraction du puits des électrons situés sur le niveau $e_2$.

La figure 4a représente un exemple de réalisation simplifié de l'invention ne comportant qu'un seul puits quantique asymétrique à barrière échelonnée.

Ce dispositif comporte :

– une couche 2 d'un matériau semiconducteur dont l'énergie potentielle du bas de la bande de conduction pour les électrons est la plus basse de la structure. Cette couche 2 constitue la partie la plus profonde du puits quantique.

– une couche 3 d'un matériau semiconducteur d'énergie intermédiaire et constituant un échelon de barrière intermédiaire.

– deux couches 1 et 4 encadrant les deux couches 2,3 et d'énergie supérieure à l'énergie intermédiaire de la couche 3. Les deux couches 1 et 4 constituent donc les échelons de barrières supérieures.

De plus, de part et d'autre de cette structure, des couches de contact (non représentées), réalisées, par exemple, par dopage de type n portent des électrodes 5 et 6.

Aux électrodes 5 et 6 est connecté un dispositif E1 d'application de champ électrique $\vec{E}$ de telle sorte que ce champ soit orienté dans le sens de la couche 3 constituant l'échelon de barrière intermédiaire vers la couche 2 constituant le puits.

Un dispositif de mesure de courant A est également connecté aux électrodes 5 et 6.

La composition des couches et leurs épaisseurs sont telles que la structure possède un premier niveau électronique permis (1) dont l'énergie est comprise entre les énergies du bas de la bande de conduction des couches 2 et 3. La structure possède un deuxième niveau électronique $e_2$ dont l'énergie est supérieure à l'énergie du bas de la bande de conduction de la couche 3 et inférieure à l'énergie du bas de la bande de conduction de la couche 4. Un tel profil de bande de conduction est représenté en figure 4b. L'écart entre les niveaux $e_1$ et $e_2$ doit correspondre à l'énergie photonique h ν à détecter.

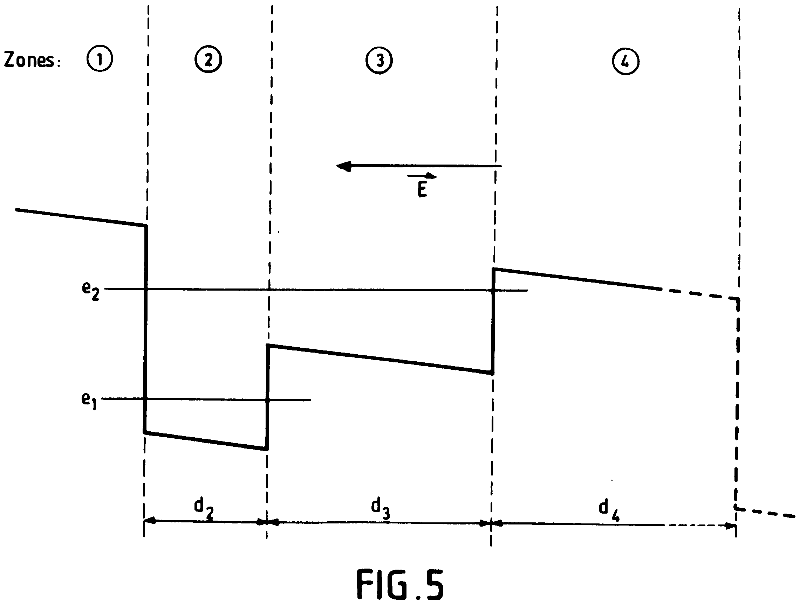

Lorsqu'un champ électrique $\vec{E}$ est appliqué à la structure par le dispositif E1, le profil de la bande de conduction s'incline comme représenté en figure 5 de façon à permettre la conduction d'électrons du niveau $e_2$ vers l'électrode 6.

Le fonctionnement de la structure de l'invention va maintenant être décrit.

Comme cela est représenté en figure 4, le dispositif comportera préférentiellement plusieurs empilements de couches constituant un empilement de puits quantiques.

Le dispositif de l'invention est donc un détecteur basé sur l'occurrence de transitions électroniques entre deux niveaux quantiques $e_1$ et $e_2$ permis pour les électrons au sein de puits de potentiel dont le profil est représenté sur la figure 4. L'association de ce type de puits pour cumuler l'effet recherché sur chacun de ces puits, conduit à une forme de bande de conduction, c'est-à-dire un profil d'énergie potentielle, également représentée sur la figure 4b, où sont indiqués les paramètres importants de la structure. L'écart énergétique h $\nu$ entre les niveaux $e_1$ et $e_2$ dépend principalement des paramètres $d_2, d_3, V_1, V_2$. Cet écart peut être également modifié par la largeur $d_4$ de la barrière la plus haute dans le cas où celle-ci est assez fine pour autoriser le couplage entre les niveaux $e_2$ de deux puits consécutifs. Pour la conception des structures, les valeurs de ces différents paramètres devront donc être déterminées pour que le dispositif présente effectivement une absorption et une détectivité importantes pour l'énergie photonique h $\nu$ désirée. L'invention repose sur deux principes. Le premier est lié au fait que le niveau $e_1$ se situe à une énergie potentielle inférieure à $V_1$ et que le niveau $e_2$ se situe lui à une énergie potentielle comprise entre $V_1$ et $V_1+V_2$. En pratique, on cherchera à obtenir une valeur importante pour $\Phi_1$ afin de limiter le courant d'obscurité. A noter encore que la réalisation de cette structure nécessite au moins 3 matériaux $M_1, M_2, M_3$ de largeurs de bandes interdites différentes. Cependant, les détecteurs à une barrière échelonnée faisant appel à un plus grand nombre de matériaux font partie de l'invention. Le second principe sur lequel repose l'invention est lié à l'asymétrie du puits. Cette asymétrie associée à la position en énergie des niveaux $e_1$ et $e_2$ par rapport à $V_1$ et $V_1+V_2$, crée un décalage prononcé de la probabilité de présence $\psi^2_2(z)$ des électrons sur le niveau $e_2$, vers la barrière échelonnée. Ainsi, en l'absence de champ électrique les électrons photo-excités sur le niveau $e_2$ sont situés préférentiellement dans les zones 3 et 4, alors que les électrons du niveau $e_1$ sont localisés principalement dans la zone 2 comme l'indique la densité de probabilité $\psi^2_1(z)$ associée au niveau $e_1$ et représentée, comme $\psi^2_2(z)$, sur la figure 4. Lors de l'application d'un champ électrique $\vec{E}$ dirigé comme l'indique la figure 5 qui illustre également la variation correspondante du profil de potentiel du puits, cette situation favorise l'extraction à l'extérieur de ce puits, des électrons situés sur le niveau $e_2$, tout en maintenant confinés à l'intérieur du puits profond (couche 2) les électrons du niveau $e_1$. A noter que pour entrer dans le cadre de l'invention le signe du champ appliqué par rapport au profil du puits, doit correspondre au cas présenté par la figure 5. En d'autres termes, le champ appliqué doit correspondre à une diminution de l'énergie potentielle des électrons, c'est-à-dire à une augmentation du potentiel, du côté de la barrière échelonnée (couches 3 et 4).

Ce type de détecteurs à puits quantiques fait appel à un dopage de type n assurant un peuplement électronique du niveau $e_1$ suffisant pour que les transitions $e_1$ vers $e_2$ se produisent effectivement. Cependant lors du fonctionnement en détecteurs de ce type de dispositifs, les puits se vident par extraction hors de ces puits, des électrons photo-excités par l'onde d'énergie h $\nu$ à détecter. Cette perte en électrons est compensée par le courant d'obscurité qui circule dans la structure. L'intérêt de l'invention est de profiter au maximum de ce courant nécessaire mais parasite, afin d'optimiser le rapport réponse/courant d'obscurité et la détectivité. En effet, en se rapportant à nouveau à la figure 5, on constate que l'extraction des électrons situés sur le niveau $e_2$ est très nettement favorisée par la répartition spatiale de ces électrons donnée par la densité de probabilité de présence indiquée sur la figure 4b. Ceci associé au fait que les transitions se produisent entre deux niveaux liés, favorise la réponse de ces détecteurs. Dans le même temps (voir figures 4b et 5), les électrons non photo-excités donc restés sur le niveau $e_1$ restent confinés dans la région 2. On limite ainsi leur participation au courant d'obscurité. Le profil des puits faisant l'objet de l'invention permet donc d'obtenir le meilleur compromis entre les deux configurations des figures 1a et 1b présentées précédemment. En effet, puisque les deux niveaux mis en jeu sont liés le dipôle d'interaction $\mu_z$ reste élevé et proche de sa valeur dans des puits du type de la figure 1a. Par contre, la probabilité d'extraction des électrons situés sur le niveau $e_2$ est plus élevée que dans un puits simple. Selon l'invention, on se rapproche ainsi du courant d'obscurité qui peut être obtenu avec des puits du type de la figure 1b.

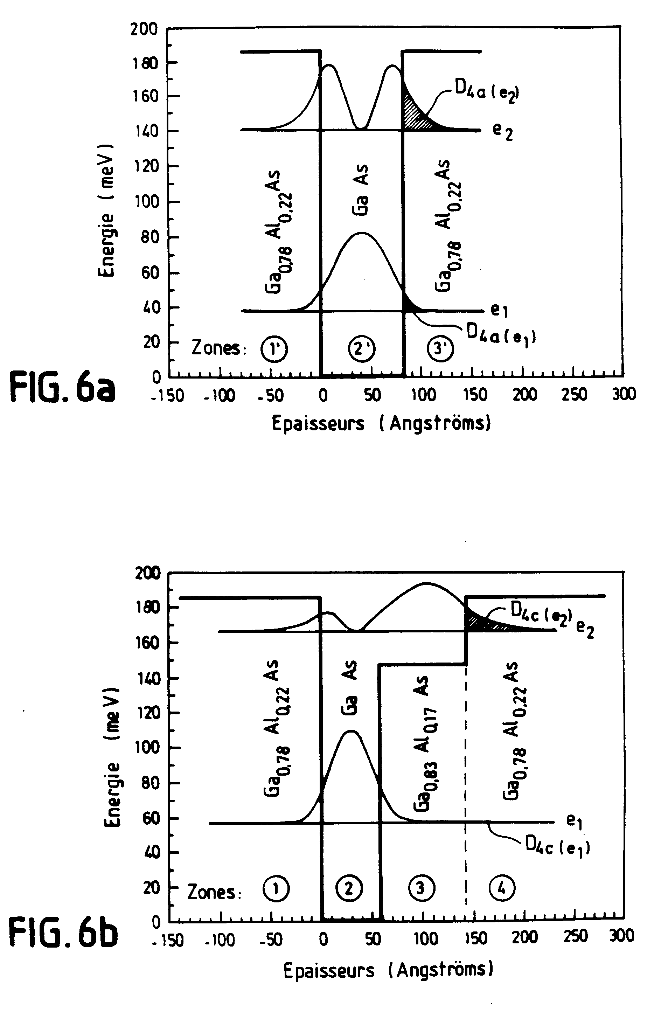

La figure 6b donne un exemple de profil de puits réalisé à partir d'alliages du type GaAlAs, qui entre dans le cadre de l'invention. Sur la figure 6a, on a également représenté un puits symétrique à barrière non échelonnée de type connu, présentant par rapport à la figure 6b, le même écart énergétique entre $e_1$ et $e_2$ et des barrières (zones 1' et 4') équivalentes aux barrières extrêmes (zones 1 et 4 correspondant aux couches 1 et 4). Sur ces figures sont aussi représentées les densités de probabilité de présence de l'électron selon l'axe Oz. Dans les deux cas, on a calculé la probabilité de présence $D_4$ de l'électron dans les zones 4' et 4 correspondant aux couches 4' et 4 (figures 6a et 6b respectivement). Dans le cas de a figure 6a nous obtenons pour $e_1$ et $e_2$ :

$$D_{4a}(e_1) = 3.39.10^{-2}$$
$$D_{4a}(e_2) = 1.68.10^{-1}$$
$$\text{et } R_{4a} = D_{4a}(e_2)/D_{4a}(e_1) = 4.96$$

Ce rapport $R_4(a)$ traduit la différence de pénétration des électrons dans la zone 4 selon qu'ils sont placés sur le niveau $e_2$ ou sur le niveau $e_1$ et donc $R_4(a)$ rend compte, dans le cas de la figure 6a, de la possibilité d'extraire de manière préférentielle les électrons situés sur le niveau $e_2$. Calculons maintenant ce même rapport $R_4$ mais dans le cas de la figure 6b correspondant à l'invention :

$$D_{4b}(e_1) = 2.88.10^{-5}$$
$$D_{4b}(e_2) = 1.16.10^{-1}$$
$$R_4(b) = D_{4b}(e_2)/D_{4b}(e_1) = 4.0277.10^4$$

On constate l'intérêt de l'invention qui permet de favoriser la différence de comportement en terme d'extraction du puits, entre les niveaux $e_1$ et $e_2$. Cependant, dans le cas de la figure 6b le dipôle d'interaction $\mu_z$ (défini au paragraphe 1.2) est plus faible que dans le cas de la figure 6a. En effet nous avons :

$$\mu_z(a) = 2.311 \text{ nm.e}$$
$$\mu_z(b) = 1.554 \text{ nm.e}$$

Or c'est, $\mu^2_z$ qui régit l'absorption liée aux transitions $e_1$ $e_2$ et influe donc directement sur la réponse du détecteur, ainsi il est nécessaire de comparer :

$$R_4(a) \, \mu^2_z(a) = 2.65.10^3$$
$$\text{et } R_4(b) \, \mu^2_z(b) = 9.73.10^6$$

Le cas de l'invention représenté en figure 6b reste donc très nettement favorable puisque ces deux grandeurs présentent un rapport de l'ordre de $10^3$.

On peut également calculer dans les deux cas, sous champ appliqué, le rapport $\rho$ entre le temps de fuite à l'extérieur du puits associé au niveau $e_2$ ($\tau_2$) et celui associé au niveau $e_1$ ($\tau_1$). Dans le cas de la figure 6a on a pour un champ appliqué tel que $\tau_2(a) = 10^{-12}$ s.

$$(a) = \tau_{2(a)}/\tau_{1(a)} \simeq 10^6$$

Par contre, dans le cas (b) :

$$(b) = \tau_{2(b)}/\tau_{1(b)} \simeq 10^9$$

L'invention permet donc de gagner un facteur $10^3$ sur le rapport des temps de fuite. De plus, le champ à appliquer pour obtenir $\tau_2 = 10^{-12}$s est de 0. 35 mV/Å dans le cas de la figure 6a alors qu'il n'est que de 0. 15 mV/Å dans le cas de l'invention (figure 6b), ce qui favorise une diminution du courant d'obscurité pour une réponse donnée.

A titre d'exemple, une forme de réalisation préférée du détecteur de l'invention est représentée en figure 6b et possède un profil de bande de conduction tel que celui de la figure 6b.

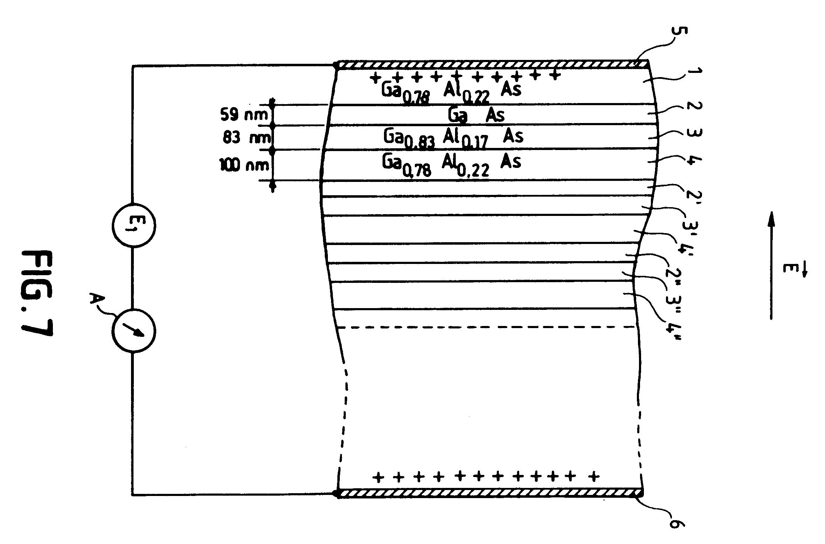

Le dispositif de la figure 7 possède un empilement de puits quantiques constitués chacun de la manière suivante :

Deux couches 2 et 3 en GaAs et $Ga_{1-y}Al_yAs$ respectivement enserrées entre deux couches 1 et 2 de $Ga_{1-x}Al_xAs$.

Avec

x compris entre 0 et 1 (par exemple 0,22).

y compris entre 0 et x (par exemple 0,17).

L'épaisseur de la couche 2 est comprise entre 1 et 10 nm (par exemple 6 nm).

L'épaisseur de la couche 3 est comprise entre 2 et 20 nm (par exemple 8 nm).

La couche barrière 4 séparant deux puits consécutifs a raisonnablement une épaisseur comprise entre 5 et 50 nm (par exemple 20 nm).

Le champ électrique appliqué à la structure est orienté dans le sens couche 3 vers couche 2.

L'invention concerne donc le domaine de la détection d'une onde électromagnétique en utilisant des transitions électroniques entre niveaux discrets d'énergie situés dans la bande de conduction de puits quantiques semiconducteurs, qui peuvent être associés en nombre important pour augmenter la réponse de ce type de détecteurs. A l'heure actuelle, les solutions existantes dans ce domaine, ne permettent pas de tirer parti au maximum du courant d'obscurité nécessaire au repeuplement des puits en électrons. Ces solutions connues font appel à des puits simples symétriques à deux niveaux liés $e_1$ et $e_2$ ou à des puits du même type mais ne présentant qu'un seul niveau lié $e_1$, les transitions se produisant alors de ce niveau $e_1$ directement vers le continuum. La première solution favorise une réponse importante, parce que les deux niveaux $e_1$, $e_2$ étant liés à la probabilité de transition $e_1$ vers $e_2$ est élevée. La deuxième solution favorise un faible courant d'obscurité mais conduit à des réponses plus faibles car la probabilité de transition $e_1$ vers le continuum est plus faible. L'idée sur laquelle l'invention repose consiste à utiliser des puits à deux niveaux liés pour favoriser la réponse mais présentant un profil de potentiel asymétrique obtenue en utilisant un échelonnement d'une des deux barrières formant le puits. Ce profil particulier permet d'augmenter la différenciation en terme de probabilité d'extraction du puits, entre le niveau $e_2$ et le niveau $e_1$, afin de favoriser le départ du puits des électrons photo-excités tout en limitant le courant d'obscurité. Ainsi, l'utilisation de puits asymétriques à une barrière échelonnée permet d'augmenter le rapport réponse/courant d'obscurité.

La description qui précède n'a été faite qu'à titre d'exemple. Différentes variantes peuvent être envisagées sans sortir du cadre de l'invention. Les exemples numériques notamment et de matériaux n'ont été fournis que pour illustrer la description.

## Revendications

1. Détecteur d'ondes électromagnétiques, caractérisé en ce qu'il comporte :

   – un empilement de couches en matériau semiconducteur (1 à 4) constituant un puits quantique dont le profil de potentiel asymétrique présente une barrière échelonnée c'est-à-dire possède un échelon de barrière intermédiaire et possédant deux niveaux d'énergie ($e_1$, $e_2$) dont l'un des niveaux est inférieur au niveau d'énergie de l'échelon de barrière intermédiaire et l'autre niveau est supérieur au niveau d'énergie de cet échelon de barrière intermédiaire ;

– des moyens d'application d'un champ électrique à la structure ;

– des moyens de détection d'un courant électrique connectés aux bornes de la structure.

2. Détecteur d'onde électromagnétique, caractérisé en ce qu'il comprend :

a) une structure semiconductrice possédant au moins un empilement d'une première, deuxième, troisième et quatrième couches (1, 2, 3, 4) dont les largeurs des bandes interdites permettent d'obtenir le profil suivant d'énergie potentielle correspondant au bas de la bande de conduction pour les électrons :

– énergie (référence O) la plus basse pour la deuxième couche ( 2 ) ;

– énergie intermédiaires (V1) pour la troisième couche (3), cette troisième couche (3) constituant une barrière interne ;

– énergies de valeurs supérieures (V1+V2) pour les première et quatrième couches (1, 4) constituant les barrières du puits ;

ladite structure est telle que :

– l'énergie correspondant à un premier niveau électronique permis (e1 ) est inférieure à l'énergie intermédiaire (V1) du bas de la bande de conduction du matériau de la troisième couche (3) ;

– l'énergie correspondant à un deuxième niveau électronique (e2 ), est comprise entre l'énergie intermédiaire (V1) du bas de la bande de conduction du matériau de la troisième couche (3) et les énergies potentielles (V1+V2) du bas de la bande de conduction des matériaux des première et quatrième couches ( 1, 4) ;

b) des moyens d'application d'un champ électrique à la structure orienté dans le sens de la troisième couche (3) vers la deuxième couche ( 2 ) ;

c) des moyens de détection d'un courant électrique connectés aux bornes de la structure.

3. Détecteur d'onde électromagnétique selon la revendication 1, caractérisé en ce que la différence des niveaux d'énergie des premier et deuxième niveaux (e1, e2) correspond sensiblement à l'énergie des photons à détecter.

4. Détecteur d'onde électromagnétique selon la revendication 1, caractérisé en ce que les largeurs de bandes interdites des première et quatrième couches (1,4) sont sensiblement équivalentes.

5. Détecteur d'onde électromagnétique selon la revendication 1, caractérisé en ce qu'il comporte au moins un premier empilement de couches (PQ1) comportant au moins la deuxième, troisième et quatrième couches (2 à 4) disposé sur la première couche (1) et, disposé sur le premier empilement, une succession d'empilements de couches (PQ2 à PQn) comportant chacun des couches identiques au premier type d'empilement (PQ1).

6. Détecteur d'onde électromagnétique selon la revendication 1, caractérisé en ce que les moyens d'application d'un champ électrique comporte des électrodes (8, 9) en contact avec les surfaces extérieures des première et quatrième couches (1, 7) et permettant la connexion des moyens de détection d'un courant électrique.

7. Détecteur d'onde électromagnétique selon la revendication 2, caractérisé en ce que :

– la première couche est en $Ga_{1-x}Al_xAs$

– la deuxième couche est en GaAs

– la troisième couche est en $Ga_{1-y}Al_yAs$

– la quatrième couche est en $Ga_{1-x}Al_xAs$

avec x compris entre 0 et 1

et y compris entre 0 et x.

**FIG.1a**

**FIG.1b**

$\vec{E}$

M₂

M₂

M₂

M₂

M₂

M₂

M₂

M₂

M₂

Bande de conduction

$M_1/n^+$

M₁

M₁

M₁

M₁

M₁

M₁

M₁

$M_1/n^+$

MPQ          Bande interdite

# FIG.2a

$\vec{E}$

M₂

M₂

M₂

M₂

M₂

M₂

M₂

M₂

M₂

Bande de conduction

$M_1/n^+$

M₁

M₁

M₁

M₁

M₁

M₁

M₁

$M_1/n^+$

MPQ          Bande interdite

# FIG.2b

Bande de conduction

$e_2$

$h\nu$

$e_1$

Bande interdite

FIG.3

FIG.4a

FIG.4b

FIG.5

FIG. 6a

FIG. 6b

FIG.7

Office européen
des brevets

# RAPPORT DE RECHERCHE EUROPEENNE

Numero de la demande

EP  91 40 1538

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| X | WO-A-9 006 596 (THOMSON-CSF) * Page 3, ligne 24 - page 5, ligne 19; page 8, ligne 27 - page 9, ligne 7; revendications 1-4; figures 1-3 * --- | 1-7 | H 01 L  31/0352 |
| A | APPLIED PHYSICS LETTERS, vol. 45, no. 6, 15 septembre 1984, pages 649-651, New York, US; D.D. COON et al.: "New mode of IR detection using quantum wells" * En entier * --- | 1,2,7 | |
| A | APPLIED PHYSICS LETTERS, vol. 52, no. 20, 16 mai 1988, pages 1701-1703, New York, US; K.W. GOOSSEN et al.: "Photovoltaic quantum well infrared detector" --- | | |
| A | US-A-4 745 452 (T.C.L.G. SOLLNER) --- | | |
| P,X | EP-A-0 407 250 (THOMSON-CSF) * Revendications; figures * ----- | 1-7 | DOMAINES TECHNIQUES RECHERCHES (Int. Cl.5)  H 01 L |

Le présent rapport a été établi pour toutes les revendications

| Lieu de la recherche | Date d'achèvement de la recherche | Examinateur |
|---|---|---|
| LA HAYE | 12-08-1991 | VISENTIN A. |

CATEGORIE DES DOCUMENTS CITES

X : particulièrement pertinent à lui seul
Y : particulièrement pertinent en combinaison avec un
    autre document de la même catégorie
A : arrière-plan technologique
O : divulgation non-écrite
P : document intercalaire

T : théorie ou principe à la base de l'invention
E : document de brevet antérieur, mais publié à la
    date de dépôt ou après cette date
D : cité dans la demande
L : cité pour d'autres raisons

.............................................................
& : membre de la même famille, document correspondant

EPO FORM 1503 03.82 (P0402)